(19) Europäisches Patentamt
European Patent Office
Office européen des brevets

(11) **EP 2 533 270 A1**

(12) **EUROPEAN PATENT APPLICATION**
published in accordance with Art. 153(4) EPC

(43) Date of publication:
**12.12.2012 Bulletin 2012/50**

(51) Int Cl.:
*H01L 21/02* (2006.01)    *C30B 29/06* (2006.01)
*C30B 33/02* (2006.01)    *H01L 21/324* (2006.01)
*H01L 29/78* (2006.01)

(21) Application number: **11739765.3**

(22) Date of filing: **02.02.2011**

(86) International application number:
**PCT/JP2011/052107**

(87) International publication number:
**WO 2011/096417 (11.08.2011 Gazette 2011/32)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **04.02.2010 JP 2010023101**

(71) Applicant: **National University Corporation
Tohoku Unversity
Sendai-shi, Miyagi 980-8577 (JP)**

(72) Inventors:
• **OHMI, Tadahiro
Sendai-shi
Miyagi 980-8577 (JP)**

• **TERAMOTO, Akinobu
Sendai-shi
Miyagi 980-8577 (JP)**
• **SUWA, Tomoyuki
Sendai-shi
Miyagi 980-8577 (JP)**

(74) Representative: **Glawe, Delfs, Moll
Patent- und Rechtsanwälte
Postfach 26 01 62
80058 München (DE)**

(54) **SILICON WAFER AND SEMICONDUCTOR DEVICE**

(57) In a silicon wafer which has a surface with a plurality of terraces formed stepwise by single-atomic-layer steps, respectively, no slip line is formed.

(Comparative Example 1)
Heat Treatment Temperature: 1100°C
Ar Flow Rate: 10L/min
Heat Treatment Time: 60min
( a )

(Example 4)
Heat Treatment Temperature: 900°C
Ar Flow Rate: 10L/min
Heat Treatment Time: 60min
( b )

(Example 1)
Heat Treatment Temperature: 850°C
Ar Flow Rate: 20L/min
Heat Treatment Time: 180min
( c )

(Example 2)
Heat Treatment Temperature: 850°C
Ar Flow Rate: 10L/min
Heat Treatment Time: 540min
( d )

FIG. 1

**Description**

Technical Field

This invention relates to a silicon wafer for forming a semiconductor device such as an IC or LSI and further relates to a semiconductor device such as an IC or LSI.

Background Art

The asperity of a surface of a silicon wafer for forming a semiconductor device such as an IC or LSI is a factor which degrades or reduces current drivability of a MOSFET (Metal Oxide Semiconductor Field Effect Transistor), as shown in, for example, Non-Patent Document 1 and, therefore, the surface is required to be as flat as possible (Non-Patent Document 1).
On the other hand, it is reported that when a silicon wafer is treated in an Ar atmosphere at 1200°C, it is possible to form an extremely flat surface on which the atomic-level step-and-terrace morphology appears (Non-Patent Document 2).

Prior Art Document

Non-Patent Document

Non-Patent Document 1: T. Ohmi, K. Kotani, A. Teramoto, and M. Miyashita, IEEE Elec. Dev. Lett., 12, 652 (1991).
Non-Patent Document 2: L. Zhong, A. Hojo, Y. Matsushita, Y Aiba, K. Hayashi, R. Takeda, H. Shirai, and H. Saito, Phy. Rev. B. 54, 2304 (1996).

Summary of the Invention

Problem to be Solved by the Invention

However, if a silicon wafer having a large diameter such as 200mm$\phi$ is heat-treated at a high temperature of 1200°C as in Non-Patent Document 2, the silicon wafer is subjected to the formation of crystal defects called slip lines, so that the yield of MOSFETs which are formed on the wafer is significantly reduced.

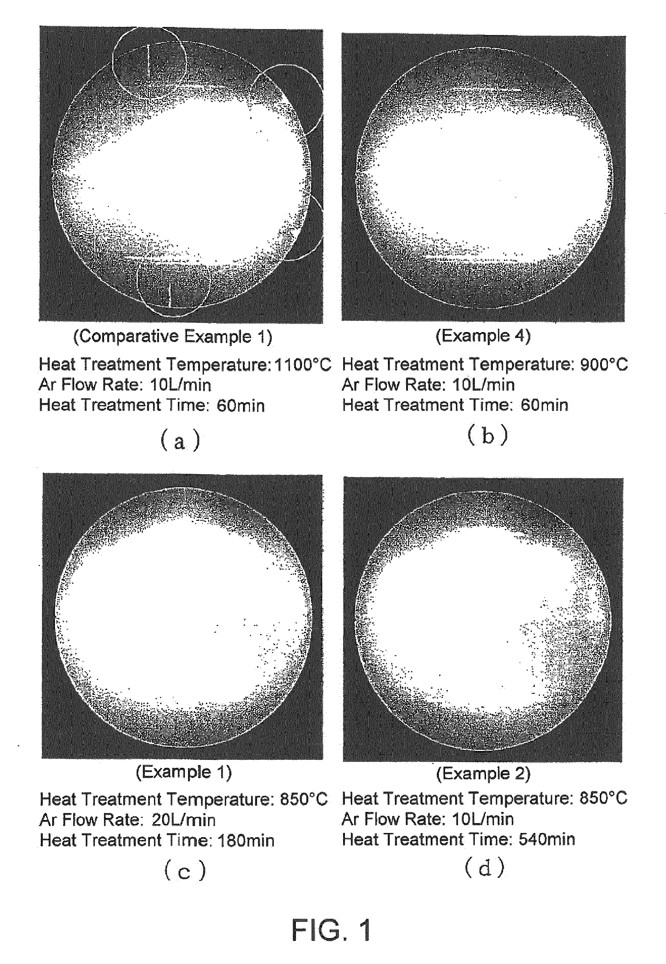

Fig. 1 (a) shows an X-ray topography (X-ray diffraction topography) analysis result obtained when the present applicant performed a heat treatment of a silicon wafer in an Ar atmosphere at 1100°C. It is seen that slip lines are formed at portions respectively surrounded by white circles.
As described above, according to the prior art, it is impossible to manufacture, with a good yield, MOSFETs and circuits formed by those MOSFETs on a large-diameter wafer having an atomically flat surface. In order to provide a high-performance semiconductor device at a low cost, it is effective to satisfy both of them.
This invention has been made in view of the above-mentioned problem and it is an object of this invention to provide a silicon wafer which has a single-atomic-layer flat surface and which, even if its diameter is large, can manufacture MOSFETs and circuits formed by those MOSFETs with a good yield.

Means for Solving the Problem

In order to solve the above-mentioned problem, according to a first aspect of this invention, there is obtained a silicon wafer which has a surface with a plurality of terraces formed stepwise by single-atomic-layer steps, respectively, and which has no slip line.
According to a second aspect of this invention, there is obtained a semiconductor device formed by using the silicon wafer according to the first aspect.
According to a third aspect of this invention, there is obtained a semiconductor device formed on a silicon substrate having atomic-order steps and terraces and having no slip line.
According to a fourth aspect of this invention, there is obtained a method of atomically flattening a silicon wafer in an inert gas atmosphere at a temperature of 900°C or less and 800°C or more.

Effect of the Invention

According to this invention, it is possible to provide a silicon wafer which has an atomically flat surface and which, even if its diameter is large, can manufacture MOSFETs and circuits formed by those MOSFETs with a good yield.

Brief Description of the Drawings

Fig. 1 is diagrams showing X-ray topography results when silicon wafers were heat-treated under various conditions.
Fig. 2 is a diagram showing a relationship between the off angle and the terrace width of a silicon wafer according to this embodiment.
Fig. 3 shows AFM images of sample surfaces in Examples 1 and 4-1 and Comparative Examples 1 and 2.
Fig. 4 is a plan view showing one example when a MOSFET is formed on a silicon wafer according to this embodiment.
Fig. 5 is a cross-sectional view in a source-drain direction of Fig. 4.
Fig. 6 shows a temperature profile during a heat treatment in Example 1.
Fig. 7 shows AFM images of sample surfaces before and after oxidation (before and after treatment) in Example 5 and Comparative Examples 3 to 5.
Fig. 8 is a diagram showing drain voltage-drain current characteristics in Example 6 and Comparative Example 6.
Fig. 9 is a cross-sectional view showing an outline of a heat treatment apparatus.
Fig. 10 shows AFM images of a sample surface in Example 4-1.
Fig. 11 is a diagram showing cumulative failure rate (Cumulative Failure [%]) evaluation results (evaluation area: 1mm $\times$ 1mm).
Fig. 12 is a diagram showing cumulative failure rate (Cumulative Failure [%]) evaluation results (evaluation area: 4mm $\times$ 4mm).

Mode for Carrying Out the Invention

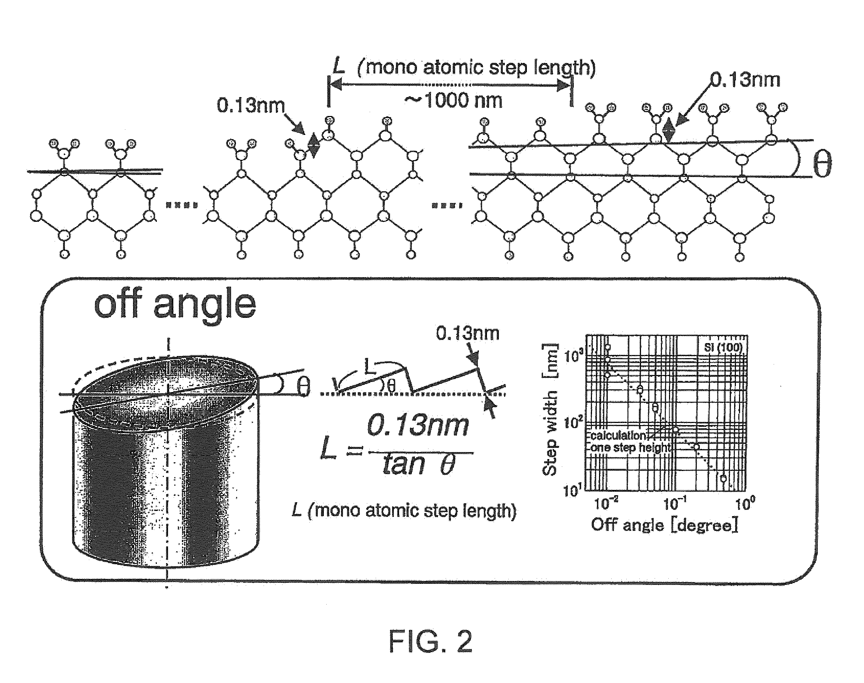

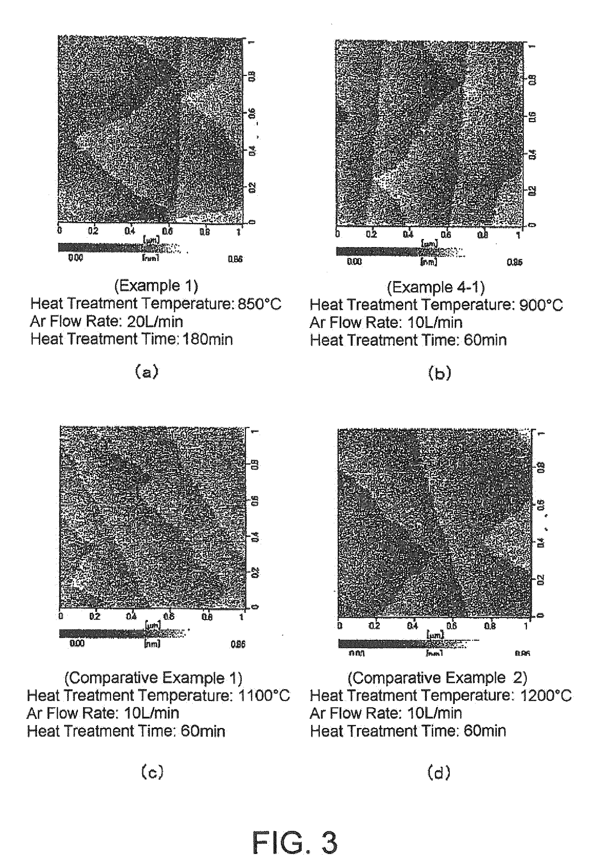

Hereinbelow, a preferred embodiment of this invention will be described in detail with reference to the drawings. First, a silicon wafer according to this embodiment will be briefly described.
A silicon wafer of this invention has a surface formed with a plurality of terraces which are formed stepwise by single-atomic-layer steps, respectively, wherein no slip line exists.
Herein, "slip line" represents a "crystal defect" that occurs due to the dislocation of regularly arranged silicon atoms at a high temperature when a silicon wafer is heat-treated, and has a crack-like shape, for example, as shown at portions respectively surrounded by white circles in Fig. 1 (a).
That is, the silicon wafer of this invention has a structure which is free of crystal defects.
On the other hand, the state in which the surface has the plurality of terraces formed stepwise by the atomic-order steps, respectively, represents a state shown in Figs. 2 and 3.
As exemplarily shown in Fig. 2, the surface of the silicon wafer according to this embodiment is inclined by an off angle ($\theta$) from a Just (100) plane.
Fig. 2 shows a state in which a crystal at a substrate surface has a (100) plane and a plane orientation is inclined by 0.06 degrees as an off angle with respect to the (100) plane in a direction inclined by 36 degrees toward a <011> direction with respect to a <01-1> direction.
When this state is imaged by, for example, an AFM (Atomic Force Microscope), the shapes shown in Fig. 3 are observed.
At the atomic level, when the substrate surface is inclined by the off angle ($\theta$), lattice points on the surface are different as shown in Fig. 2. Steps $S_A$ and $S_B$ appear at positions where the lattice points on the surface change. The height of each step is 0.13nm which corresponds to a mono atomic step on the silicon (100) surface.
The number of steps and terraces at this time is, as shown in Fig. 2, given by a formula (1).

$$L = 0.13 / \tan\theta \ (nm) \qquad (1)$$

L: terrace width, $\theta$: off angle from the (100) plane

The terrace widths have variation of several atoms at the atomic level. However, the variation is as small as on the order of nm and falls within a range so that the influence on characteristics is negligible or small. Accordingly, the terrace widths can be said to be substantially the same. Further, the directions of the steps are not aligned in a straight line and differ by several atoms at the atomic level. However, the difference is also as small as on the order of nm and falls within a range so that the influence on characteristics is negligible or small. Accordingly, the directions of the steps can be regarded to be substantially linear and aligned in one direction so that the steps can be said to be formed substantially in the same direction. The relationship between the terrace width L obtained from each AFM image and the off angle obtained by X-ray diffraction measurement well agrees with the result of the formula (1). That is, the steps formed on the silicon surface are each in the form of a single atomic layer. Further, likewise, the off angles can also be said to be substantially the same angle as an average angle. In the following description, it will simply be indicated that the step directions are the same, the terrace widths are the same, and the off angles are the same.

In order to obtain the silicon wafer having the surface formed with the plurality of terraces which are formed stepwise by the single-atomic-layer steps, respectively, and having no slip line as described above, the temperature in a heat treatment is preferably set to 900°C or less. By setting the heat treatment temperature to 900°C or less, it is possible to obtain a silicon wafer with no slip line even if the diameter of the wafer is set to as large as 200mm$\phi$ or more.

However, since the atomically flat surface cannot be obtained by a heat treatment at an excessively low temperature, the temperature in the heat treatment is preferably set to 800°C or more.

When forming MOSFETs, the above-mentioned silicon wafer which has the surface formed with the plurality of terraces formed stepwise by the single-atomic-layer steps, respectively, and which has no slip line makes it possible to form the MOSFETs with a good yield without degrading the current drivability of the MOSFETs.

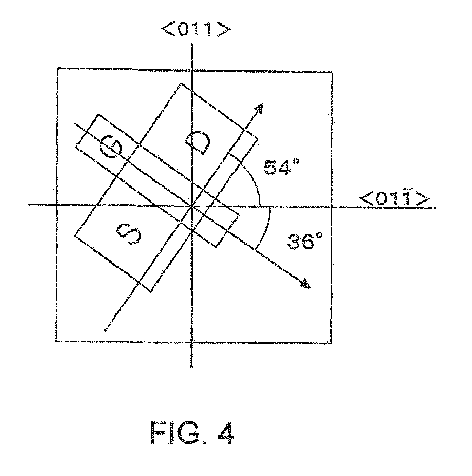

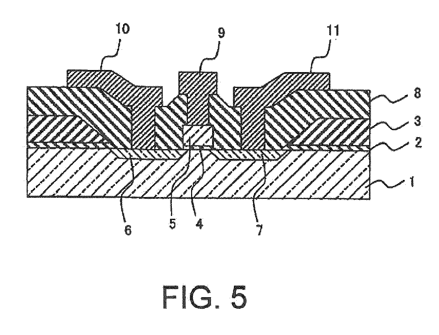

Herein, a method of forming a MOSFET using the silicon wafer according to this embodiment will be described with reference to Figs. 4 and 5.

First, a surface of a semiconductor substrate 1 (silicon wafer, silicon substrate) having been subjected to the above-mentioned treatment (heat treatment at 900°C or less) is cleaned by a cleaning method using no alkaline solution.

Then, as shown in Fig. 5, a $SiO_2$ film 2 is formed by radical oxidation which directly oxidizes the substrate surface by oxygen radicals generated by, for example, plasma, and then a $SiO_2$ film 3 is formed by CVD or the like.

Then, an active region where a MOS transistor is to be formed is opened by photolithography or the like. In this event, as shown in Fig. 4, it is preferable to set a carrier traveling direction to a direction parallel to steps so that the steps do not exist in a source-drain direction (the steps do not cross the carrier traveling direction). With this configuration, it is possible to realize a MOSFET in which the roughness is extremely small and the carrier mobility is high in the carrier traveling direction.

Fig. 4 exemplifies a case where the source-drain is set in a direction inclined by 54 degrees toward a <011> direction with respect to a <01-1> direction.

Then, the $SiO_2$ film 2 and the $SiO_2$ film 3 at an opening portion are removed using a photoresist as a mask material and then the photoresist is removed. Although the opening is formed at each of a plurality (large number) of portions where transistors are to be formed, respectively, Figs. 4 and 5 show one of the opening portions and one of the transistors. Thereafter, the exposed semiconductor surface is cleaned by the cleaning method using no alkaline solution. Then, a $SiO_2$ film 4 is formed as a gate insulating film by radical oxidation and polycrystalline polysilicon is formed as a gate electrode 5. In the case of isotropic oxidation such as radical oxidation, the interface flatness is not degraded regardless of the film thickness. The gate insulating film may be formed by radical nitridation or may be formed by a combination of radical oxidation and radical nitridation.

Thereafter, the MOSFET is formed by a known MOSFET forming method.

Specifically, the MOSFET shown in Fig. 5 is formed by forming a source diffusion layer 6 and a drain diffusion layer 7, by forming an interlayer insulating film 8, opening contact holes, and by forming a gate extraction electrode 9, a source extraction electrode 10, and a drain extraction electrode 11.

The MOSFET forming method is not particularly limited. As a method of forming the gate insulating film, use may be made of, for example, a method of isotropically oxidizing or nitriding the semiconductor substrate. As a method for element isolation between the transistors formed in large number, use may be made of STI (Shallow trench Isolation), LOCOS (Local Oxidation of Silicon), or the like. As an active region surface cleaning method and an oxide or nitride film forming method, use may be made of any method as long as the film thickness is on the same level.

As described above, according to this embodiment, the silicon wafer is specified by a surface which has the plurality of terraces formed stepwise by the single-atomic-layer steps, respectively, and which has no slip line.

Consequently, using this silicon wafer makes it possible to manufacture MOSFETs and circuits formed by those MOSFETs with a good yield, even if the diameter of the wafer is large (200mm$\phi$ or more),

Examples

Hereinbelow, this invention will be described in further detail with reference to Examples.

<Slip-Line Evaluation>

Samples were prepared by heating silicon wafers each having a surface of (100) orientation at various heat treatment temperatures and the presence or absence of slip line was evaluated. Specific sequences are as follows.

(1) Sample Preparation

(Example 1)

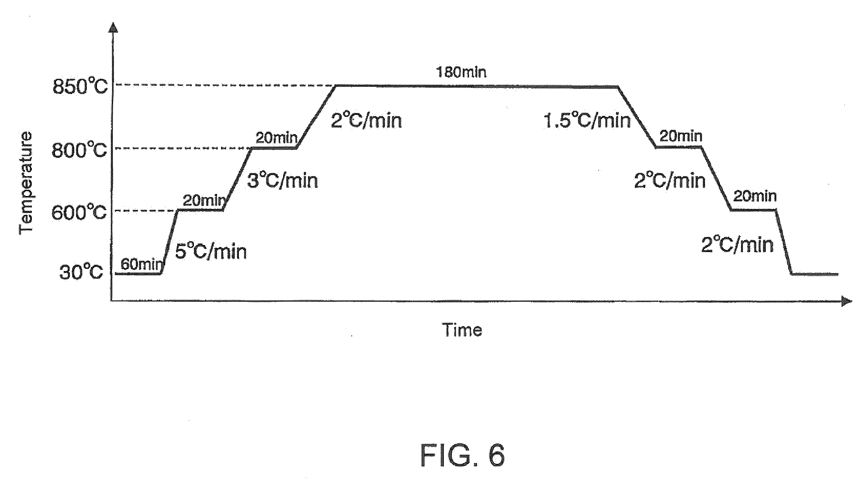

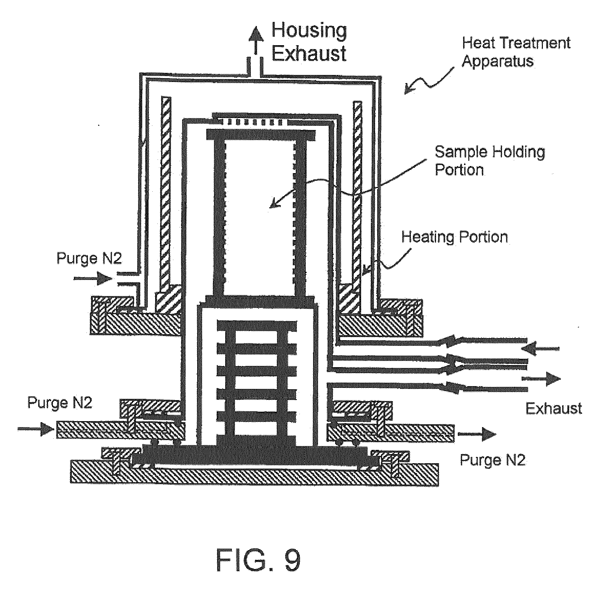

First, a silicon wafer which had a diameter of 200mm$\phi$ and which had a surface of (100) orientation was prepared and the silicon wafer surface was cleaned in the following sequence.
First, the silicon wafer surface was cleaned with $O_3$ water for 10 minutes, cleaned with dilute HF (0.5wt%) for 1 minute, and finally rinsed with ultrapure water for 3 minutes.
Then, the silicon wafer was placed in a heat treatment apparatus shown in Fig. 9. While Ar which included 0.2ppb or less of moisture and 0.1ppb or less of $O_2$ was caused to flow at a flow rate of 20L/min, a heat treatment was carried out under conditions of a heat treatment temperature of 850°C and a heat treatment time of 180 minutes.
Specifically, first, the silicon wafer was heated from 30°C to 850°C in a temperature sequence shown in Fig. 6 and was held at 850°C for 180 minutes. Thereafter, the temperature of the silicon wafer was lowered to 30°C in a temperature sequence shown in Fig. 6.
A sample was prepared in the sequence described above.

(Example 2)

A sample was prepared under the same conditions as in Example 1 except that the Air flow rate was set to 10L/min and the heat treatment time (holding time) to 540 minutes.

(Example 3)

A sample was prepared under the conditions as in Example 1 except that the Air flow was set to 10L/min and the heat treatment time (holding time) to 270 minutes.

(Example 4-1)

A sample was prepared under the same conditions as in Example 1 except that the Ar flow rate was set to 10L/min, the heat treatment temperature to 900°C, and the heat treatment time (holding time) to 60 minutes.

(Example 4-2)

A sample was prepared under the same conditions as in Example 1 except that the Ar flow was set to 14L/min, the heat treatment temperature to 800°C, and the treatment time (holding time) to 90 minutes.

(Comparative Example 1)

A sample was prepared under the same conditions as in Example 1 except that the Ar flow rate was set to 10L/min, the heat treatment temperature (holding temperature) to 1100°C, and the heat treatment time (holding time) to 60 minutes.

(Comparative Example 2)

A sample was prepared under the same conditions as in Example 1 except that the Ar flow rate was set to 10L/min, the heat treatment temperature (holding temperature) to 1200°C, and the heat treatment time (holding time) to 60 minutes.

(2) Sample Evaluation

By using X-ray topography (X-ray diffraction topography), the presence or absence of slip line of each prepared sample was evaluated. RU-300 manufactured by Rigaku Denki K.K. was used in the evaluation and the presence or absence of slip line was evaluated by a transmission X-ray topograph.

Further, a surface of each sample was observed using an AFM (SP1400 manufactured by Seiko Instruments Inc.). The off angle and direction of each sample were measured using an X-ray diffraction apparatus (X'pert Pro manufactured by PANalytical, Inc.).

Evaluation results are shown in Table 1 and transmission X-ray topographs of Examples 1, 2, and 4 (4-1, 4-2) and Comparative Example 1 are shown in Fig. 1.

AFT images of Examples 1 and 4-1 and Comparative Examples 1 and 2 are shown in Fig. 3.

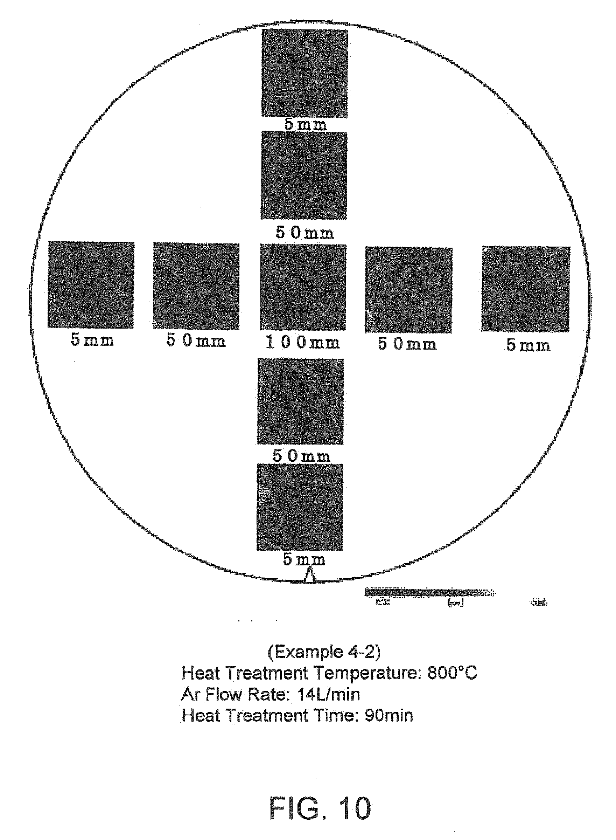

Further, AFM images of Example 4-2 are shown in Fig. 10. The AFM images at upper, lower, left, and right ends were respectively measured at places 5mm away from the edge of the wafer. The center AFM image was measured at the central portion (100mm from the wafer edge). The AFM images between the central portion and the upper, lower, left, and right ends, respectively, were measured at places 50mm away from the edge of the wafer.

[Table 1]

| No. | Heat Treatment Temperature | Ar Flow Rate | Heat Treatment Time | Slip Line |
|---|---|---|---|---|
| Example 1 | 850°C | 20L/min | 180min | none |
| Example 2 | 850°C | 10L/min | 540min | none |
| Example 3 | 850°C | 10L/min | 270min | none |
| Example 4-1 | 900°C | 10L/min | 60min | none |
| Example 4-2 | 800°C | 14L/min | 90min | none |
| Comparative Example 1 | 1100°C | 10L/min | 60min | yes |
| Comparative Example 2 | 1200°C | 10L/min | 60min | yes |

As is from Table 1 and Figs. 1 and 10, no slip line appeared in any of the samples heat-treated at 900°C or less (Examples 1 to 4 (4-1, 4-2)) and thus it is seen that no crystal defect occurred due to the heat treatment. No other surface or point defect was observed either.

On the other hand, in Comparative Examples 1 and 2, slip lines were observed (see Fig. 1 (a)) and thus it is seen that the crystal defects occurred due to the heat treatment.

Further, as is clear from Figs. 3 and 10, all the samples were each observed to have a surface formed with a plurality of terraces which were formed stepwise by atomic-order steps, respectively, and thus it is seen that the atomically flat surfaces were obtained in all the samples.

<Evaluation of Surface Asperity with Radical Oxidation>

Various treatments were applied to the surfaces of the obtained samples, thereby evaluating the shapes of the flat surfaces. Specific sequences are as follows.

(1) Sample Preparation

(Example 5)

By using a microwave-excited plasma apparatus manufactured by Tokyo Electron Ltd., the sample of Example 1 was radically oxidized under conditions of a temperature of 400°C, 133Pa, and a $Kr/O_2$ flow rate ratio of 98/2, thereby forming an oxide layer of 6nm.

Thereafter, the oxide film was removed using a solution in which 36wt% HCl and 50wt% HF were mixed at 19/1.

The removal of the oxide film was judged by confirming the hydrophobicity.

(Comparative Example 3)

By using $\alpha$-8 manufactured by Tokyo Electron Ltd., the sample of Example 1 was heated in an $O_2$ atmosphere at a temperature of 900°C for 10 minutes to thermally oxidize the surface of the sample, thereby forming an oxide layer of 6nm.

Thereafter, the oxide film was removed using a solution in which 36wt% HCl and 50wt% HF were mixed at 19/1.

The removal of the oxide film was judged by confirming the hydrophobicity.

(Comparative Example 4)

By using α-8 manufactured by Tokyo Electron Ltd., the sample of Example 1 was heated in an $O_2$ atmosphere at a temperature of 1000°C for 10 minutes to thermally oxidize the surface of the sample, thereby forming an oxide layer of 17nm.

Thereafter, the oxide film was removed using a solution in which 36wt% HCl and 50wt% HF were mixed at 19/1.
The removal of the oxide film was judged by confirming the hydrophobicity.

(Comparative Example 5)

The sample of Example 1 was cleaned for 1 minute using a solution in which 36wt% HCl and 50wt% HF were mixed at 19/1, and then was rinsed with ultrapure water for 5 minutes (that is, the surface was not oxidized).

(2) Sample Evaluation

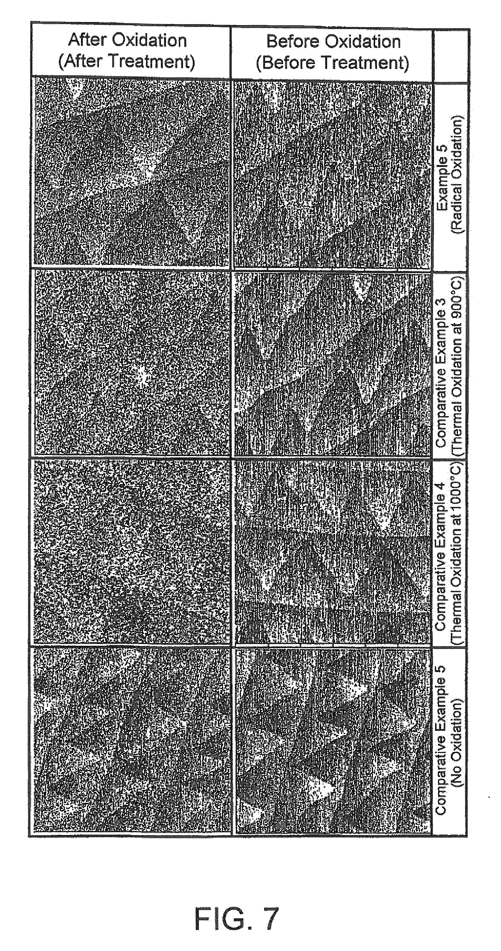

Then, the surface shapes of Example 5 and Comparative Examples 3 to 5 before and after the oxidation (before and after the cleaning in Comparative Example 5) were observed by using an AFM. The results are shown in Fig. 7. AFM images of Fig. 7 are each 1 μm square.

As shown in Fig. 7, it is seen that steps and terraces clearly appeared on the surface even after the oxidation in the radically oxidized sample (Example 5) and thus that the surface flatness on the atomic order was maintained.

On the other hand, it is seen that steps and terraces became unclear in the thermally oxidized samples (Comparative Examples 3 and 4) and thus that the surface flatness on the atomic order was degraded.

<evaluation of MOSFET Current-Voltage Characteristics>

MOSFETs like the one shown in Figs. 4 and 5 were formed in the following sequence and the drain current-drain voltage ($I_D$-$V_D$) characteristics were evaluated.

(1) Sample Preparation

(Example 6)

First, the surface of the sample of Example 1 was cleaned by a cleaning method using no alkaline solution, which is described in T. Ohmi, "Total room temperature wet cleaning Si substrate surface," J. Electrochem. Soc., Vol. 143, No. 9, pp. 2957-2964, Sep. 1996.

Then, a $SiO_2$ film 2 of 7nm was formed under a condition of a temperature of 400°C by radical oxidation which directly oxidizes the substrate surface by oxygen radicals generated by plasma, and then a $SiO_2$ film 3 of 300nm was formed by CVD.

Then, an active region where a MOS transistor was to be formed was opened by photolithography.

By using a photoresist as a mask material, the $SiO_2$ film 2 and the $SiO_2$ film 3 at an opening portion were removed by a solution of HCl/HF=19/1. Then, the photoresist was removed by a solution of $H_2SO_4/H_2O_2$=4:1. Thereafter, the exposed semiconductor surface was cleaned by the above-mentioned cleaning method using no alkaline solution. Then, a $SiO_2$ film 4 was formed to 5.6nm as a gate insulating film by radical oxidation and polycrystalline polysilicon was formed as a gate electrode 5. Thereafter, formation of a source diffusion layer 6 and a drain diffusion layer 7, formation of an interlayer insulating film 8, opening of contact holes, and formation of a gate extraction electrode 9, a source extraction electrode 10, and a drain extraction electrode 11 were carried out by a known technique, thereby completing the MOSFET shown in Fig. 5.

(Comparative Example 6)

A MOSFET was formed under the same conditions as in Example 5 except that Ra=0.06nm without carrying out the flattening treatment.

(2) Sample Evaluation

Drain currents were measured by applying to the prepared samples drain voltages by steps of 0.5V in the range of -3V to 3V.

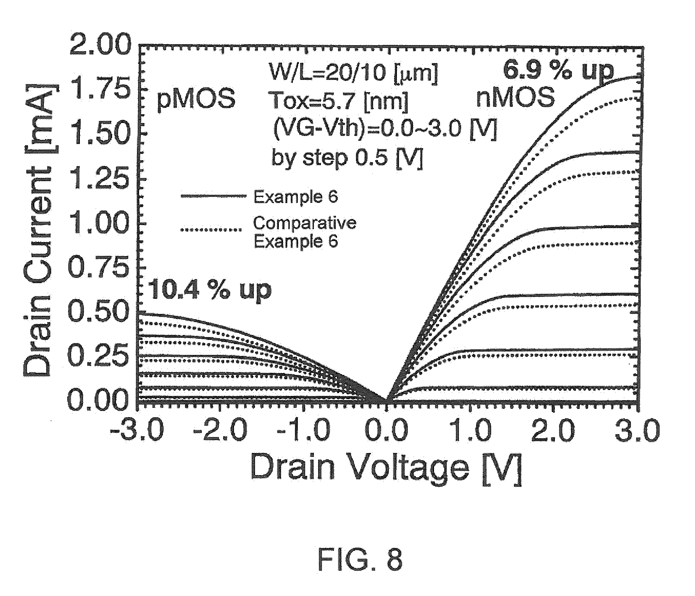

The results are shown in Fig. 8.

As is clear from Fig. 8, a drain current in the MOSFET of Example 6 having the flat interface was greater than that in the MOSFET of Comparative Example 6 when the same gate and drain voltages were applied, and thus it is seen that the excellent MOSFET was formed.

<Cumulative Failure Rate (Cumulative Failure [%]) Evaluation>

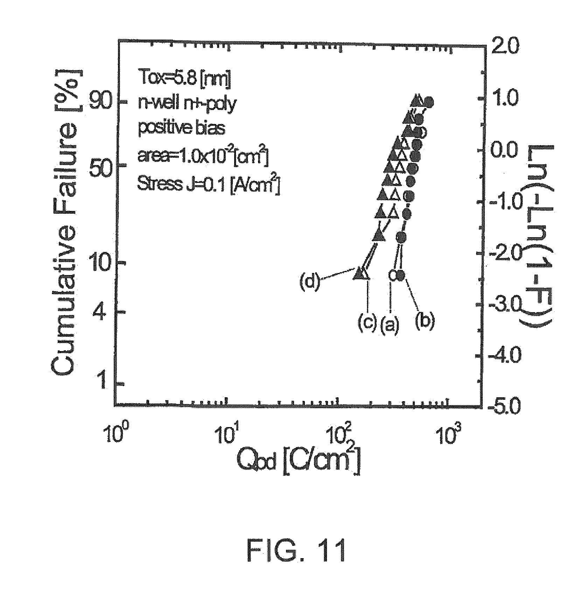

Fig. 11 is a diagram showing the results of conducting cumulative failure rate evaluation by setting the evaluation area to 1mm × 1mm. The abscissa axis represents the quantity of charge (charges to breakdown) Qbd that flows until breakdown, white the ordinate axis represents the cumulative failure rate. The performance increases as moving rightward in the graph.

In Fig. 11 (a) represents a case where a surface was atomically flattened by setting the treatment temperature to 1100°C, (b) represents a case where a surface was atomically flattened by setting the heat treatment temperature to 800°C, (c) represents a case where no atomically flattening treatment was carried out, and (d) represents a case where the surface roughness was increased by APM after carrying out a flattening treatment. Fig. 11 shows the results of measurement which was carried out by forming an oxide film of 5.8nm on respective samples by radical oxidation to produce MOS diodes.

From the results shown in Fig. 11, it is seen that Qbd was larger in the flattened samples, i.e. (a) and (b), than in the samples with a greater roughness, i.e. (c) and (d).

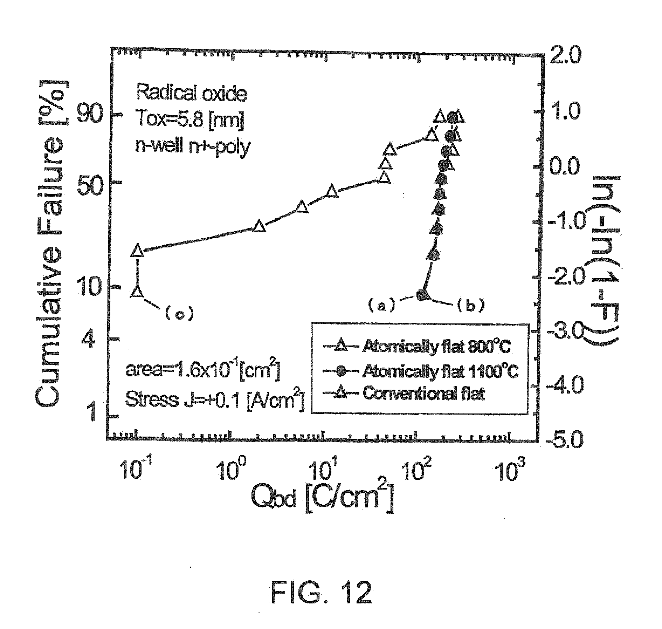

Fig. 12 is a diagram which likewise shows the results of conducting cumulative failure rate evaluation by setting the evaluation area to 4mm × 4mm.

In Fig. 12 (a) represents a case where a surface was atomically flattened by setting the heat treatment temperature to 1100°C, (b) represents a case where a surface was atomically flattened by setting the heat treatment temperature to 800°C, and (c) represents a case where no atomically flattering treatment was carried out. Fig. 12 shows the results of measurement which was carried out by forming an oxide film of 5.8nm on respective samples by radical oxidation to produce MOS diodes.

From the results shown in Fig. 12, it is seen that when the evaluation was performed with the large-area sample, initial failure can be removed by carrying out the flattening treatment.

Industrial Applicability

In the above-mentioned embodiment, the description has been given only of the case where this invention is applied to MOSFETs. However, this invention is by no means limited thereto and is applicable to any structure using a silicon wafer having a flat surface.

**Claims**

1.   A silicon wafer which has a surface with a plurality off terraces formed stepwise by single-atomic-layer steps, respectively, and which has no slip line.

2.   The silicon wafer according to claim 1, having a diameter of 200mmφ or more in size.

3.   The silicon wafer according to claim 1 or 2, subjected to a heat treatment in an inert gas atmosphere at a temperature of 900°C or less.

4.   The silicon wafer according to any of claims 1 to 3, wherein the surface has a plane orientation of (100) crystal plane.

5.   A semiconductor device formed by using the silicon wafer according to any one of claims 1 to 4.

6.   A semiconductor device formed on a silicon substrate having single-atomic-layer steps and terraces and having no slip line.

7.   The semiconductor device according to claim 5 or 6, which is formed in an inert gas atmosphere at a temperature of 900°C or less and has a gate insulating film formed by radical oxidation and/or radical nitridation.

8.   A method of atomically flattening a silicon wafer in an inert gas atmosphere at a temperature of 900°C or less.

(Comparative Example 1)

Heat Treatment Temperature: 1100°C
Ar Flow Rate: 10L/min
Heat Treatment Time: 60min

（a）

(Example 4)

Heat Treatment Temperature: 900°C
Ar Flow Rate: 10L/min
Heat Treatment Time: 60min

（b）

(Example 1)

Heat Treatment Temperature: 850°C
Ar Flow Rate: 20L/min
Heat Treatment Time: 180min

（c）

(Example 2)

Heat Treatment Temperature: 850°C
Ar Flow Rate: 10L/min
Heat Treatment Time: 540min

（d）

FIG. 1

FIG. 2

(Example 1)
Heat Treatment Temperature: 850°C
Ar Flow Rate: 20L/min
Heat Treatment Time: 180min

(a)

(Example 4-1)
Heat Treatment Temperature: 900°C
Ar Flow Rate: 10L/min
Heat Treatment Time: 60min

(b)

(Comparative Example 1)
Heat Treatment Temperature: 1100°C
Ar Flow Rate: 10L/min
Heat Treatment Time: 60min

(c)

(Comparative Example 2)
Heat Treatment Temperature: 1200°C
Ar Flow Rate: 10L/min
Heat Treatment Time: 60min

(d)

FIG. 3

FIG. 4

FIG. 5

FIG. 6

| After Oxidation (After Treatment) | Before Oxidation (Before Treatment) | |
|---|---|---|
| | | Example 5 (Radical Oxidation) |
| | | Comparative Example 3 (Thermal Oxidation at 900°C) |
| | | Comparative Example 4 (Thermal Oxidation at 1000°C) |
| | | Comparative Example 5 (No Oxidation) |

FIG. 7

FIG. 8

Housing
Exhaust

Heat Treatment
Apparatus

Sample Holding
Portion

Heating Portion

Purge N2

Purge N2

Exhaust

Purge N2

FIG. 9

(Example 4-2)
Heat Treatment Temperature: 800°C
Ar Flow Rate: 14L/min
Heat Treatment Time: 90min

FIG. 10

FIG. 11

FIG. 12

## INTERNATIONAL SEARCH REPORT

| International application No. |
| --- |
| PCT/JP2011/052107 |

**A. CLASSIFICATION OF SUBJECT MATTER**
*H01L21/02*(2006.01)i, *C30B29/06*(2006.01)i, *C30B33/02*(2006.01)i, *H01L21/324*
(2006.01)i, *H01L29/78*(2006.01)i

According to International Patent Classification (IPC) or to both national classification and IPC

**B. FIELDS SEARCHED**

Minimum documentation searched (classification system followed by classification symbols)
H01L21/02, C30B29/06, C30B33/02, H01L21/324, H01L29/78

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>A | JP 2002-255700 A (Canon Inc.),<br>11 September 2002 (11.09.2002),<br>paragraphs [0022] to [0040]; fig. 1<br>(Family: none) | 1,2,4-6<br>3,7,8 |
| X<br>A | JP 2006-80294 A (Hitachi Kokusai Electric Inc.),<br>23 March 2006 (23.03.2006),<br>paragraphs [0026] to [0038]; fig. 4 to 7<br>(Family: none) | 1,2,5,6<br>3,4,7,8 |
| X<br>A | JP 2005-142445 A (National Institute of Advanced Industrial Science and Technology),<br>02 June 2005 (02.06.2005),<br>paragraphs [0014] to [0025]; fig. 1 to 4<br>(Family: none) | 1,2,5,6<br>3,4,7,8 |

☒ Further documents are listed in the continuation of Box C. ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>28 February, 2011 (28.02.11) | Date of mailing of the international search report<br>08 March, 2011 (08.03.11) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2011/052107

C (Continuation).   DOCUMENTS CONSIDERED TO BE RELEVANT

| Category* | Citation of document, with indication, where appropriate, of the relevant passages | Relevant to claim No. |
|---|---|---|
| X<br>A | JP 2003-324106 A  (Hitachi Kokusai Electric Inc.),<br>14 November 2003 (14.11.2003),<br>paragraphs [0031] to [0046]<br>& US 2003/0170583 A1 | 1,2,5,6<br>3,4,7,8 |

Form PCT/ISA/210 (continuation of second sheet) (July 2009)

**INTERNATIONAL SEARCH REPORT**

International application No.

PCT/JP2011/052107

| Box No. II | Observations where certain claims were found unsearchable (Continuation of item 2 of first sheet) |

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

| Box No. III | Observations where unity of invention is lacking (Continuation of item 3 of first sheet) |

This International Searching Authority found multiple inventions in this international application, as follows:
    A silicon wafer, which is characterized in that the wafer has no slip line, is described in JP 2002-255700 A (Canon Inc.), 11 September 2002 (11.09.2002), [0022] - [0040], fig. 1, (Family: none); JP 2006-80294 A (Hitachi Kokusai Electric Inc.), 23 March 2006 (23.03.2006), [0026] - [0038], fig. 4 - 7, (Family: none); JP 2005-142445 A (National Institute of Advanced Industrial Science and Technology), 2 June 2005 (02.06.2005), [0014] - [0025], fig. 1 - 4, (Family: none); and JP 2003-324106 A (Hitachi Kokusai Electric Inc.), 14 November 2003 (14.11.2003), [0031] - [0046], & US 2003/0170583 A1.
    (continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**   ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

| INTERNATIONAL SEARCH REPORT | International application No. |
|---|---|
| | PCT/JP2011/052107 |

Continuation of Box No.III of continuation of first sheet(2)

Therefore, the invention in claim 1 cannot be considered to be novel in the light of the above-said documents, and does not have a special technical feature.
Consequently, any same or corresponding special technical feature cannot be found among the invention in claim 1 and the inventions in claims 2 - 8, and therefore, said claims lack unity of invention.

Form PCT/ISA/210 (extra sheet) (July 2009)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **T. OHMI ; K. KOTANI ; A. TERAMOTO ; M. MIYA-SHITA.** *IEEE Elec. Dev. Lett.,* 1991, vol. 12, 652
- **L. ZHONG ; A. HOJO ; Y. MATSUSHITA ; Y AIBA ; K. HAYASHI ; R. TAKEDA ; H. SHIRAI ; H. SAITO.** *Phy. Rev. B.,* 1996, vol. 54, 2304

- **T. OHMI.** Total room temperature wet cleaning Si substrate surface. *J. Electrochem. Soc.,* September 1996, vol. 143 (9), 2957-2964